Europäisches Patentamt

European Patent Office

Office européen des brevets

(19)

(11) Publication number : **0 450 980 A1**

## (12) EUROPEAN PATENT APPLICATION

(21) Application number : 91303032.6

(22) Date of filing : 05.04.91

(51) Int. Cl.⁵ : **H01L 23/051**

(30) Priority : 06.04.90 FR 9004449

(43) Date of publication of application :
09.10.91 Bulletin 91/41

(84) Designated Contracting States :
**DE FR GB IT**

(71) Applicant : **MOTOROLA SEMICONDUCTEURS
S.A.**
**Centre Electronique de Toulouse Avenue
General Eisenhower
F-31023 Toulouse Cédex (FR)**

(72) Inventor : **Estrade, Andre**
**12 rue Saint-Perier**
**F-31270 Villeneuve, Tolosane (FR)**

(74) Representative : **Lupton, Frederick et al**
**Motorola, European Intellectual Property
Operations, Jays Close, Viables Ind. Estate
Basingstoke, Hants, RG22 4PD (GB)**

(54) Improvements in or relating to semi-conductor device packaging.

(57)  In a packaging (10) for a semi-conductor device formed on a semi-conductor die (18), a carrier member (11) is formed out of a cylinder of copper to include a rebate (17) and a rounded shoulder (16). One side of the die (18) is fixed in the rebate by solder (19) applied between the die and the rebate bottom. A cap member (12) is arranged to enter the rebate. Cap member (12) includes a base portion (14) to provide a solderable surface. The cap member (12) is soldered to the other side of the die (18) by a soldering (100). The void between the cap member (12) and carrier member (11) are filled with a potting compound.

*FIG.1*

EP 0 450 980 A1

## Field of the Invention

The present invention relates to semi-conductor device packaging, that is to say the structure within which the device is contained in use for its protection.

## Background of the Invention

Packaging, in addition to providing physical protection for a device, may be adapted to provide straight forward electrical connection and a thermal connection for conducting heat generated within the device in use away from the device. This latter function is particular important for so called power devices (devices capable of high heat dissipation) and can be a determining factor in the selection of packaging. In packaging for a power semi-conductor diode for example, the semi-conductor die on which the device is formed may be soldered directly onto a metal carrier forming part of its packaging, providing good electrical connection and thermal connection for the soldered side of the die.

In one common form of packaging, the metal carrier takes the form of a cylindrical pellet of nickel plated copper having a flat surface to which die may be soldered. Assembly of the packaging is completed by soldering the opposite face of the die to a similar flat cylindrical metal carrier whilst injecting insulating material around the die in the gap between the carriers to prevent them from mating.

Such packaging has a number of clear advantages when used for power diode devices for example. The electrode connections may be made directly onto the packaging itself without need for wires, as can the thermal connections to provide conduction of heat away from the device; importantly heat conduction is provided away from both sides of the die. This translates into a highly power capable device with a high surge capability. The manufacturing process is straightforward and easily mechanised leading to a cheap and electrically reliable component. The packaging itself is compact.

Unfortunately, such packaging does exhibit a number of disadvantages which make it unpopular in some applications. Firstly, the symmetry of the package means that it must either be marked and inspected before installation to ensure correct polarity, or a characterising measurement performed upon installation. Secondly the device is mechanically weak to any forces attempting to separate the carriers, any stress being transferred directly to the soldered die. To overcome this latter disadvantage, the packaged device is typically delivered partially enclosed in an insulating protector of plastics material spanning a joining region of the carriers to provide mechanical strength. This extra component and manufacturing step detract from the cost advantage of the package.

Where good physical performance together with low cost is desired, an alternative form of packaging is popular wherein the die is mounted in a rebate formed in a cylindrical carrier to which one side of the die is soldered, forming one electrode connection. Construction is completed by soldering a wire to the other side of the die to provide the other electrode connection and finally filling the rebate with polling compound to seal the arrangement. It will be apparent that this packaging provides better physical protection for the die and is inherently asymmetric, thereby easing the problem of electrically correct final installation. However, the thermal (and hence maximum electrical) performance of the device is compromised since thermal transfer is essentially only from one side of the die, the wire bond providing an inferior thermal path.

## Summary of the Invention

In accordance with the present invention there is provided packaging for a semi-conductor device including:

a carrier member having a rebate to receive semi-conductor die carrying the device;

a cap member;

first affixing means adapted to affix one side of the semi-conductor die in thermal contact with said carrier member; and

second affixing means adapted to affix a further side of the semi-conductor die in thermal contact with said cap member; the cap member entering the rebate.

In a preferred form of the present invention the first and second affixing means comprise solder.

Preferably, the cap member or the carrier member are in electrical contact with semi-conductor die, with the cap member and the carrier member being a close fit.

Preferably, the cap member is rebated; the die entering the rebate.

In one form of the present invention the device is a diode and the cap member and the carrier member are insulated one from another.

The void between the cap member and the carrier member may be filled with a potting compound.

## Detailed Description of the Invention

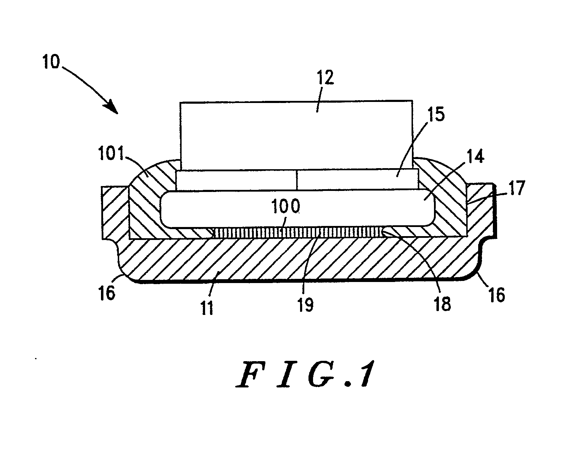

In order that features of the present invention may be further appreciated, an embodiment will now be described with reference to the accompanying diagrammatic drawing (Fig 1).

In a packaging 10 for a semi-conductor device formed on a semi-conductor die 18, a carrier member 11 is formed out of a cylinder of copper to include a rebate 17 and a rounded shoulder 16. The carrier, once formed, is nickel plated. One side of the die 18 is fixed in the rebate by solder 19 applied between the die and the rebate bottom. A cap member 12 is arranged to enter the rebate and is similarly formed in nickel plated copper. Cap member 12 includes a base portion 14 to provide a solderable surface and a portion having flats such as flat 15 for ease of mechanised handling. The cap member 12 is soldered to the other side of the die 18 by a soldering 100. The void between the cap member 12 and carrier member 11 is filled with a potting compound 101, of for example multipoint dispensor. Alternatively, an automatic filler may be applied.

It will be appreciated the invention provides an advantageous packaging for a semi-conductor device, particularly a power diode where the cap member 12 and carrier member 11 may constitute the device electrodes. Notably, the rebate provides physical protection for the device whilst heat transfer occurs from both sides of the device; yet the package is asymmetric for installation. The use of solder to fix the respective sides of the die 18 to the cap member 12 and carrier member 11 ensures that uniform contact is made therebetween: this provides uniform thermal and electrical connections which is particularly important for power semi-conductor devices since it improves the power capability of such devices. The packaging is susceptible to mechanised fabrication and the finished article is compact. Importantly, it may be used as a replacement for prior art packages directly but without the attendant physical limitation of those packages.

## Claims

The matter for which the applicant seeks protection is:-

1. Packaging for a semi-conductor device including:
    a carrier member having a rebate to receive semi-conductor die carrying the device;
    a cap member;
    first affixing means adapted to affix one side of the semi-conductor die in thermal contact with said carrier member; and
    second affixing means adapted to affix a further side of the semi-conductor die in thermal contact with said cap member; the cap member entering the rebate.

2. Packaging for a semi-conductor device as claimed in claim 1 wherein the first and second affixing means comprise solder.

3. Packaging for a semi-conductor device as claimed in claim 1 or claim 2 and wherein the cap member or the carrier member are in electrical contact with semi-conductor die.

4. Packaging for a semi-conductor device as claimed in claim 1, 2 or claim 3 and wherein the cap member and the carrier member are a close fit.

5. Packaging for a semi-conductor device as claimed in claim 1, 2, 3 or claim 4 and wherein the cap member is rebated; the die entering the rebate.

6. Packaging for a semi-conductor device as claimed in any preceding claim and wherein the device is a diode.

7. Packaging for a semi-conductor device as claimed in any preceding claim and wherein the cap member and the carrier member are insulated one from another.

8. Packaging for a semi-conductor device as claimed in any preceding claim and wherein void between the cap member and the carrier member is potted.

*F I G . 1*

**European Patent Office**

# EUROPEAN SEARCH REPORT

Application Number

EP 91 30 3032

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | FR-A-2 361 747 (SIEMENS) * Figure 3; claim 1 * | 1 | H 01 L 23/051 |
| A | --- | 3-8 | |
| A | US-A-4 329 707 (WESTINGHOUSE) * Figure 1; claim 1; column 3, lines 5-14 * | 1-3,6-8 | |
| A | --- DE-B-1 136 016 (SIEMENS) * Figure 2; Claim 1 * | 1,3,6,7 | |
| A | --- DE-A-2 138 457 (SIEMENS) * Figure 1; claim 1 * ----- | 1,3,6,7 | |

|  |  |  | TECHNICAL FIELDS SEARCHED (Int. Cl.5) |
|---|---|---|---|
|  |  |  | H 01 L |

The present search report has been drawn up for all claims

| Place of search | Date of completion of the search | Examiner |
|---|---|---|
| THE HAGUE | 29-05-1991 | DE RAEVE R.A.L. |

EPO FORM 1503 03.82 (P0401)